Europäisches Patentamt

European Patent Office

Office européen des brevets

(11) Publication number: **0 223 136**
**A2**

# (12) EUROPEAN PATENT APPLICATION

(21) Application number: **86115153.8**

(22) Date of filing: **31.10.86**

(51) Int. Cl.⁴: **G02B 5/28**

(30) Priority: **18.11.85 US 799362**

(43) Date of publication of application:
**27.05.87 Bulletin 87/22**

(84) Designated Contracting States:
**DE FR GB**

(71) Applicant: **International Business Machines Corporation**
**Old Orchard Road**
**Armonk, N.Y. 10504(US)**

(72) Inventor: **Gutleben, Christian Daniel**
**602 E. Stoughton**
**Champaign Illinois 61820(US)**
Inventor: **Yao, Ying Luh**
**P.O. Box 497**
**Millwood New York 10546(US)**

(74) Representative: **Mönig, Anton, Dipl.-Ing.**
**Schönaicher Strasse 220**
**D-7030 Böblingen(DE)**

(54) **Planar process and structure for spectral filters in an optoelectronic device.**

(57) Bandpass or band reject spectral filters for a monolithic optoelectronic device are produced by a planar process compatible with the semiconductor process utilized to produce the optoelectronic device. The filter is comprised of a number of layers of material normally used in a semiconductor process. The thickness of layers applied over an imaging are are modulated to create the interference filters of a necessary characteristics. In an MOS-type process, a given pixel area consists of a set of layers of silicon oxide, polysilicon and silicon nitride with specific thickness dimensions.

## FIG. 1

## FIG. 2

EP 0 223 136 A2

## PLANAR PROCESS AND STRUCTURE FOR SPECTRAL FILTERS IN AN OPTOELECTRONIC DEVICE

This invention is in the field of multilayer spectral filters. Specifically, it relates to the creation and structure of such devices within the limits of Silicon semiconductor technology and to the kinds of applications thereby allowed.

Generally, the prior art falls into two categories: the multilayer approach to spectral filtering and the application of spatially miniture filters to imaging and display.

Multilayer spectral filtration is now within the domain of elementary textbooks, and is the basis for much capital within the optics community. However in their present form, multilayer filters consist of macroscopic stacks of films residing on a glass or quartz substrate. Often these films are formed of relatively exotic materials using standard macroscopic thin film processes such as sputtering. Consequently, this technology has made little or no progress in the past years.

Recently however, with the increasing interest in compact image input devices, there has arisen a need for an inexpensive method of producing large arrays of very small adjacent filters. Prior art in this area is centered around the neutral density type filter technology. Here a single layer of specialized organic or inorganic material is used to literally absorb the unwanted optical energy and to transmit the wanted light. The drawback to this approach is that it has little compatibility with the scanner/display technology that it is meant to augment. The materials used are not part of standard silicon, germanium or gallium arsenide technology, and the lithography is at best of a crude optical form. It is evident therefore, that these techniques will eventually fail to produce the increasingly fine line widths required by newer devices.

A number of patents are directed to neutral density type filter technology. For example, Japanese patent 57-148367 to Fuji discloses a process which uses organic neutral density filters to achieve color imaging.

U.S. Patent 4,387,987 to Koike et al discloses an organic neutral density filter in which there is careful size control of the lateral dimensions of the filter.

U.S. Patent 4,418,284 to Ogawa et al discloses a process for fabricating an organic density filter, with the bonding of the organic filter to silicon, rather than incorporating the filters as part of the silicon.

U.S. Patent 3,868,172 to Li et al discloses a multilayer filter in which the materials used are electrically controllable, and the materials are not compatible with the semiconductor process. The resultant structure is too large to fit on an image, and the total transmission through a given band is too low for realistic imaging.

The cited art sets forth various methods of using neutral density approaches and organic dyes to form optoelectronic filters, however, there is no teaching in any of the cited art of utilizing semiconductor techniques to produce a multilayer interference filter.

The invention as claimed solves the problem of how to devise spectral filters in an optoelectronic device. The term 'spectral filter' is thereby to include an array of spatially microscopic spectral filters as well as spectral filters which form a monolithic component of a solid state scanner and display.

Specifically, the processes and materials of semiconductor technology are combined to produce microminiature multilayer interference filters. The thickness of layers applied over an imaging area are modulated to create the filters. In a metal oxide semiconductor (MOS) process, a given pixel area consists of a substrate and an overlaying set of layers of silicon oxide, polysilicon and silicon nitride.

The invention is described in more detail below with reference to drawings which illustrate only specific embodiments.

FIG. 1 is a diagram of a filter array of an optoelectronic scanner.

FIG. 2 is a representation of three adjacent pels of the optoelectronic scanner of FIG. 1.

Fig. 3 is a diagram of a single interface for incident light.

FIG. 4 is a diagram of a multilayer interface for incident light.

FIG. 5 is the spectral response calculated for the filters shown in FIG. 1.

Fig. 6 is a representation of a band reject filter constructed from layers of standard silicon materials.

FIG. 7 is a diagram of the spectral response of the structure of FIG. 4.

In a semiconductor process alternating layers of materials are either deposited or grown on a bulk substrate according to required patterns and to specified thicknesses. The precision with which this can be accomplished is very great, and as the technology progresses, becoming greater. This technology to create spatially precise stacks of thin films -stacks which can include the films associated with the device structure itself. These multilayer stacks form a dielectric interference filter that can be designed to have almost any reasonable spectral transmission characteristic. As examples of this system, two possible applications are considered.

First, to allow a solid state scanner to provide color information, pixel sized filters must be installed over the imaging area. There can be as many as 500,000 of these approximately 15 micron square filters on some scanners, so the technology for producing them must be fairly sophisticated. It is found however, that even within the constraints imposed by the device multilayers themselves, a small set of thin film thicknesses can be specified which together will provide most conceivable spectral filter profiles. These layers are generally applied in exactly the same manner as standard semiconductor device films are now applied. Specifically, if the layers are applied by Molecular beam epitaxy or chemical vapor deposition, then the filter to filter layer differences are easier to handle. Other process methods might require masking the selective back etching but even in that situation the technology is relatively simple.

Another possible application for these filters is in display devices which selectively pass white light through some kind of shutter. Examples are liquid crystal or thin film transistor (TFT) displays. The multilayer structure of the device itself presents no contraint because the device is likely built upon a transmitting glass substrate hence the filters can be placed on the empty side.

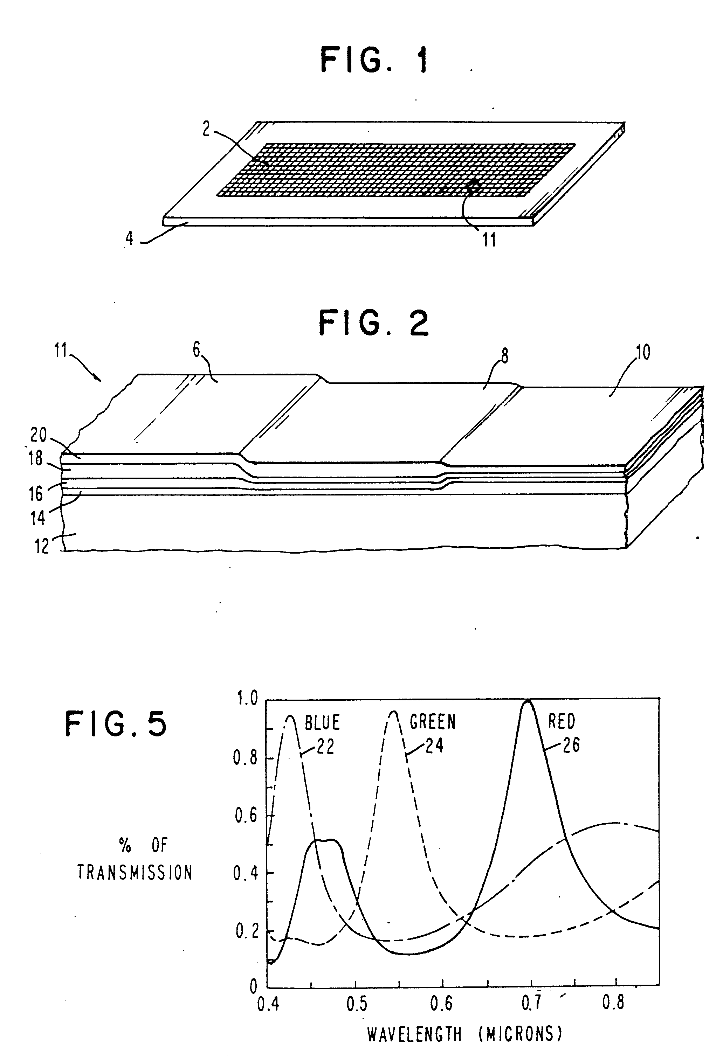

FIG. 1 illustrates an array 2 of spectral filters formed by a semiconductor process on a light receiving source, such as a photosensor 4. Alternatively, the photosensor 4 may be replaced by a light source such as an array of light emitting diodes. This is due to the bidirectional light transmission characteristics of the array 2.

FIG. 2, three adjacent pels 11 in the filter array 2 of FIG. 1 are illustrated. The pels are comprised of a red section 6, a green section 8 and a blue section 10. These array sections 11 are formed on a substrate 12 utilizing a semiconductor planar process technology, which is set forth in detail at pages 64-73 of "Physics of Semiconductor Device" by S. M. Sze; John Wiley & Sons (1981). The described planar process is modified in the sense that layer thicknesses have been changed to provide the proper interference spectra in accordance with the dielectric constants of the various materials used.

The substrate 12 may be formed of silicon or glass, with the following description being relative to a silicon substrate 12. The planar process set forth above, is utilized to form a silicon oxide (SiO) layer 14 on the substrate 12, with a polysilicon (Si) layer 16 formed on top of layer 14. A SiO layer 18 is then formed on layer 16, with a top layer of silicon nitride 20 being formed on top of layer 18. The red 6, green 8 and blue 10 sections each have different layer thicknesses, as set forth in the table below, to provide the required spectral responses. The layer thicknesses may vary on the order of ± 3% from the values shown in the table.

| COLOR → | RED | GREEN | BLUE |
|---|---|---|---|
| Material | | Thicknesses | |
| SiNitride (20) | 95 microns | 120 microns | 100 microns |
| SiO (18) | 118 microns | 44 microns | 14 microns |
| poly Si (16) | 97 microns | 68 microns | 37 microns |
| Sio (14) | 85 microns | 70 microns | 125 microns |

The following is a brief description of the steps taken to calculate the transmission efficiency of a multilayer structure such as shown in FIG. 2, considering a normal incidence of light.

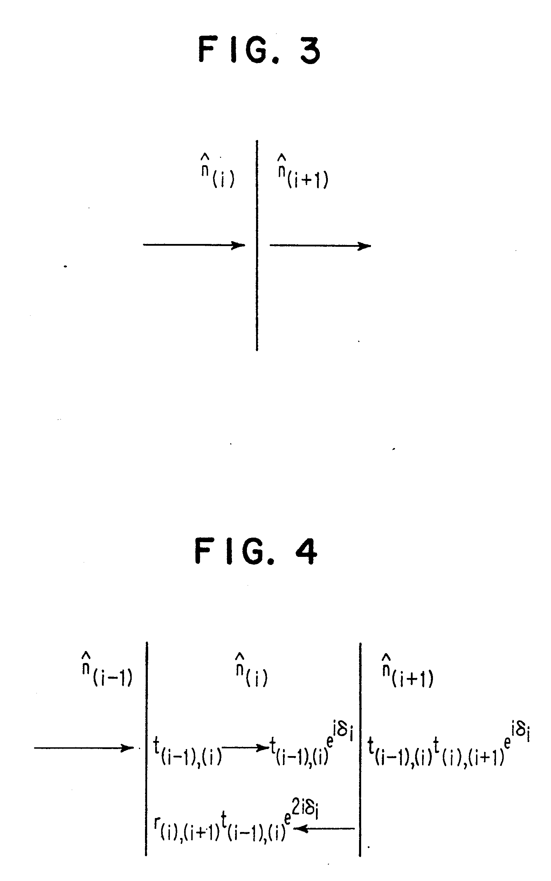

An algorithm for computing the transmission of a multilayer stack starts with the simple Fresnel coefficients (FIG. 3):

$$(1) \qquad r^0_{i,i+1} = \frac{E_r}{E_0} = \frac{\hat{n}_{i+1} - \hat{n}_i}{\hat{n}_{i+1} + \hat{n}_i}$$

$$(2) \qquad t^0_{i,i+1} = \frac{E_t}{E_0} = \frac{2\hat{n}_t}{\hat{n}_{i+1} + \hat{n}_i}$$

Here $\hat{n}_i = n_i + jk_i$ and $k_i = \alpha_i\lambda/4\pi$ where $\alpha_i$ is the absorbtion coefficient and $n_i$ is the index of refraction of layer i. Now if we label these as the zeroth order coeffficients then the standard etalon equations look like - (FIG. 4):

$$(3) \qquad r_i^{IL} = \frac{r_{i-1,i}^0 + r_{i,i+1}^0 \; \exp \; i2\delta_i}{1 + r_{i-1,i}^0 r_{i,i+1}^0 \; \exp \; i2\delta_i}$$

$$(4) \qquad t_i^{IL} = \frac{t_{i-1,i}^0 t_{i,i+1}^0 \; \exp \; i\delta_i}{1 + r_{i-1,i}^0 r_{i,i+1}^0 \; \exp \; i2\delta_i}$$

$$(5) \qquad r_i^{IR} = \frac{r_{i+1,i}^0 + r_{i,i-1}^0 \; \exp \; i2\delta_i}{1 + r_{i+1,i}^0 r_{i,i-1}^0 \; \exp \; i2\delta_i}$$

$$(6) \qquad t_i^{IR} = \frac{t_{i+1,i}^0 t_{i,i-1}^0 \; \exp \; i\delta_i}{1 + r_{i+1,i}^0 r_{i,i-1}^0 \; \exp \; i2\delta_i}$$

Delta is defined as $\delta_i = 2\pi \hat{n}_i d_i/\lambda$ and $d_i$ is the thickness of a given layer i. L and R indicate the light waves travelled to the left and right resepctively. Now treating this etalon as a single effective interface and adding more layers iteratively, the relations become:

$$(7) \qquad r_i^{(j)L} = \frac{r_i^{(j-1)L} - r_{i+1,i+2}^0 \; \exp \; i2\delta_{i+1}}{1 + r_i^{(j-1)L} r_{i+1,i+2}^0 \; \exp \; i2\delta_{i+1}}$$

$$(8) \qquad t_i^{(j)L} = \frac{t_i^{(j-1)L} t_{i+1,i+2}^0 \; \exp \; i\delta_{i+1}}{1 + r_i^{(j-1)L} r_{i+1,i+2}^0 \; \exp \; i2\delta_{i+1}}$$

The final intensity transmission is then:

(9) $T = (n_{exit}/n_o)\,|t|$

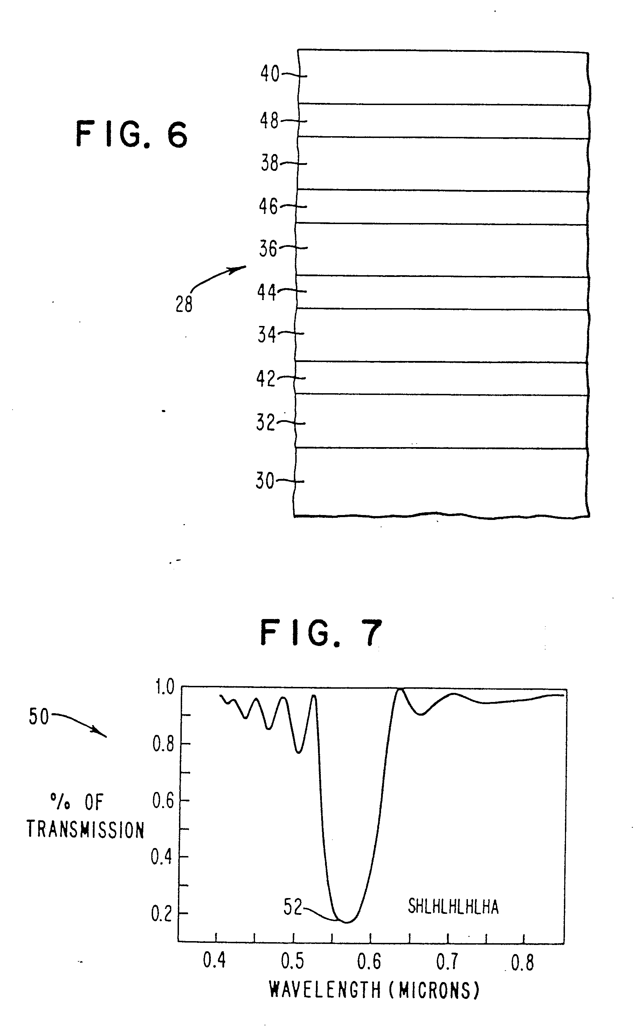

FIG. 5 is a spectral response curve for the different colors of light to be passed by the different sections of the bandpass filters of the array as depicted in the table above. The blue response is illustrated by curve 22, the green response by curve 24 and the red response by curve 26.

Band reject filters may likewise be constructed utilizing the planar process techniques described above. One such band reject filter 28 is illustrated in FIG 6. Band reject filters are also known in the art as band suppression filters or notch filters.

A substrate 30 is formed of glass or silicon, with the following description being relative to a glass substrate 30 having a thickness on the order of 2 millimeters. The planar process above is utilized to form alternating layers of silicon nitride and silicon oxide on the glass substrate 30, with the bottom and top layers each being formed of silicon nitride. The bottom layer 32 and layers 34, 36, 38 and 40 are formed of silicon nitride having a layer thickness on the order of 200 microns. The layers 42, 44, 46 and 48 are formed of silicon oxide having a layer thickness on the order of 125 microns. The respective layers may vary on the order of ± 3% from the thickness levels given above. The transmission efficiency is once again calculated aa shown in the equation above.

A spectral response curve 50 for the band reject filter 28 is shown in FIG. 7. The curve 52 illustrates the wavelength of light that is blocked by the filter 28.

## Claims

1. A bandpass spectral filter comprised of:

a substrate (12);

a first oxide layer (14) of a predetermined thickness formed on said substrate;

a polysilicon layer (16) of a predetermined thickness formed on said first oxide layer;

a second oxide layer (18) of a predetermined thickness formed on said polysilicon layer; and

a nitride layer (20) of a predetermined thickness formed on said second oxide layer (FIG. 2).

2. A band reject spectral filter comprised of:

a substrate (30);

alternating layers (32-40) of a predetermined thicknesses of nitride and oxide formed on said substrate, with the top and bottom layers each being formed of nitride (FIG. 6).

3. The combination as recited in claims 1 or 2, wherein said substrate (12, 30) is formed of silicon or glass.

4. The combination as recited in one of the preceding claims, wherein said nitride layers are silicon nitride and said oxide layers are silicon oxide.

5. The combination as recited in one of the preceding claims, adapted for a monolithic optoelectronic device wherein the substrate (12, 30) includes a photocollection area.

6. The combination as recited in one of claims 1 or 2 to 5, wherein said filter is comprised of red, green and blue sections (6, 8, 10).

7. The combination as recited in claim 6, wherein:

said red section (6) has a first silicon oxide layer thickness on the order of 0.085 microns, a polysilicon layer thickness on the order of 0.0975 microns, a second silicon oxide layer thickness on the order of 0.118 microns and a silicon nitride thickness on the order of 0.095 microns;

said green section (8) has a first silicon oxide layer thickness on the order of 0.070 microns, a polysilicon layer thickness on the order of 0.0683 microns, a second silicon oxide layer thickness on the order of 0.044 microns and a silicon nitride layer thickness on the order of 0.120 microns; and

said blue section (10) has a first silicon oxide layer thickness on the order of 0.125 microns, a polysilicon layer thickness on the order of 0.0370 microns, a second silicon oxide layer thickness on the order of 0.014 microns, and a silicon nitride layer thickness on the order of 0.100 microns (FIG. 2).

8. The combination as recited in one of the claims 2 to 5, wherein each silicon nitride layer (32, 34, ...) has a layer thickness on the order of 200 microns and each silicon oxide layer (42, 44, ...) has a layer thickness on the order of 125 microns (FIG. 6)

9. The combination as recited in claim 8, wherein there are five silicon nitride layers and four silicon oxide layers.

10. A method of forming a bandpass spectral filter in an optoelectronic device, comprising the steps of:

forming a photocollection area in a semiconductor substrate (12);

overlaying said substrate with a first layer (14) of silicon oxide;

overlaying said first layer of polysilicon with a layer (16) of polysilicon;

overlaying said layer of polysilicon with a second layer (18) of silicon oxide; and

overlaying said second layer of silicon oxide with a layer (20) of silicon nitride.

11. The method as recited in claim 10 for forming a multilayer bandpass spectral filter, comprised of a plurality of red, green and blue sections (6, 8, 10), and including the steps of:

overlaying said substrate (12) with a first layer (14) of silicon oxide having in each red section (6) a layer thickness on the order of 0.070 microns and having in each blue section (10) a layer thickness on the order of 0.125 microns;

overlaying said first layer (14) of silicon oxide with a layer (16) of polysilicon having in each red section a layer thickness on the order of 0.975 microns, having in each green section a layer thickness on the order of 0.683 microns ad having in each blue section a layer thickness on the order of 0.037 microns;

overlaying said layer (16) of polysilicon with a second layer (18) of silicon oxide having in each red section a layer thickness on the order of 0.118 microns, having in each green section a layer thickness on the order of 0.044 microns and having in each blue section a layer thickness on the order of 0.014 microns; and

overlaying said second layer (18) of silicon oxide with a layer (20) of silicon nitride having in each red section a layer thickness on the order of 0.095 microns, having in each green section a layer thickness on the order of 0.120 microns and having in each blue section a layer thickness on the order of 0.100 microns.

12. A method of forming a multilayer band reject filter, said method comprising the steps of:

forming alternating layers (32, 42, 34, 44, ...) of nitride and oxide on a substrate (30), with the top and bottom layers (32, 40) each being formed of nitride.

13. The method as recited in one of the claims 10 to 12, wherein said substrate is formed of silicon or glass, said nitride layers are formed of silicon ntride and said oxide layers are formed of silicon oxide.

14. The method as recited in one of claims 12 or 13, wherein each silicon nitride layer has a layer thickness on the order of 200 microns and each silicon oxide layer has a layer thickness on the order of 125 microns.

# FIG. 1

# FIG. 2

# FIG. 5

% OF TRANSMISSION

WAVELENGTH (MICRONS)

# FIG. 3

$\hat{n}_{(i)}$ | $\hat{n}_{(i+1)}$

# FIG. 4

$\hat{n}_{(i-1)}$ | $\hat{n}_{(i)}$ | $\hat{n}_{(i+1)}$

$t_{(i-1),(i)} \longrightarrow t_{(i-1),(i)}e^{i\delta_i}$ | $t_{(i-1),(i)}t_{(i),(i+1)}e^{i\delta_i}$

$r_{(i),(i+1)}t_{(i-1),(i)}e^{2i\delta_i} \longleftarrow$

# FIG. 6

# FIG. 7

% OF TRANSMISSION

SHLHLHLHLHA

WAVELENGTH (MICRONS)